# FASCICULE DE BREVET EUROPEEN

(11) **EP 0 905 776 B1**
(45) Date de publication et mention de la délivrance du brevet: **07.09.2005**
(21) Numéro de dépôt: 98402318.4
(22) Date de dépôt: 21.09.1998
(51) Int. Cl.: H01L 23/50, G01R 31/316

(54) **Dispositif semi-conducteur à deux plots de connexion de masse reliés à une patte de connexion de masse et procédé pour tester un tel dispositif**
Halbleiteranordnung mit zwei mit einem Erdungsanschluss verbundenen Erdungsverbindungspunkten und Testverfahren dafür
Semiconductor device comprising two ground contact pads connected to a ground connection lead and testing procedure for the device

(30) Priorité: 29.09.1997 FR 9712066
(43) Date de publication de la demande: 31.03.1999
(73) Titulaire: STMicroelectronics S.A., 92120 Montrouge (FR)
(72) Inventeur: Monnot, Gilles, 38400 Saint Martin D'Herbes (FR)
(74) Mandataire: Casalonga, Axel

(56) Documents cités:
- EP-A- 0 306 656
- EP-A- 0 622 733
- GB-A- 2 061 617
- PATENT ABSTRACTS OF JAPAN vol. 13, no. 195 (E-754), 10 mai 1989 & JP 01 015949 A (TOSHIBA), 19 janvier 1989
- PATENT ABSTRACTS OF JAPAN vol. 12, no. 425 (E-681), 10 novembre 1988 & JP 63 164353 A (HITACHI), 7 juillet 1988

## Description

La présente invention concerne le domaine des dispositifs semi-conducteurs et celui des procédés permettant de tester la qualité de la fabrication ou le bon fonctionnement de tels dispositifs.

Parmi les dispositifs semi-conducteurs connus, il en existe certains qui comprennent une pastille formant un circuit intégré, munie d'une multiplicité de plots de connexion sélective aux composants du circuit intégré, et une multiplicité de pattes de connexion extérieure reliées sélectivement auxdits plots de connexion de la pastille par une multiplicité de fils de connexion, l'ensemble étant encapsulé dans une résine de telle sorte que seules les extrémités des pattes de connexion s'étendent à l'extérieur du boîtier ainsi formé.

Il est habituel qu'après leur fabrication, les dispositifs semi-conducteurs soient testés avant d'être commercialisés. Les tests appliqués sont principalement de deux ordres.

Une première série de tests, dits de continuité de conduction, consiste à vérifier si les fils de connexion ne sont pas coupés ou en contact avec d'autres, c'est-à-dire en court-circuit, et si les soudures de leurs extrémités sur les plots de connexion de la pastille et sur les pattes de connexion ont été convenablement effectuées. Pour celà, on relie sélectivement les pattes de connexion à une source de courant et on constate si le courant passe ou ne passe pas. Si le courant ne passe pas, le dispositif semi-conducteur testé est rejeté.

Une seconde série de tests consiste à vérifier le bon fonctionnement des circuits internes de la pastille. Si le bon fonctionnement n'est pas constaté, le dispositif semi-conducteur testé est rejeté.

En vue de supprimer une patte de connexion ou de lui attribuer une autre fonctionnalité, il arrive que l'on relie une patte de connexion extérieure, constituant une patte de masse, à deux plots de connexion de la pastille, constituant deux plots de masse du circuit intégré, qui sont en particulier destinés à constituer les masses de deux parties fonctionnellement dissociées du circuit intégré. Le document JP01015949 (Toshiba Audio Video Eng.), publié le 19.01.1989 décrit un circuit de ce type.

Il s'avère que dans ce cas, les tests précités de continuité de conduction ne sont plus applicables aux fils de connexion d'une seule patte de connexion de masse reliée à deux plots de connexion de la pastille. C'est donc uniquement au cours des tests de fonctionnement d'un tel dispositif semi-conducteur que son rejet éventuel pour malfaçon desdites connexions filaires peut être effectué, alors qu'il serait économiquement intéressant de pouvoir rejeter un tel dispositif semi-conducteur mal fabriqué dès la première série de tests de continuité de conduction.

La présente invention a pour but de palier cet inconvénient et propose un dispositif semi-conducteur dont la structure est particulièrement adaptée pour pouvoir vérifier la qualité des liaisons électriques entre les pattes de connexion de masse et les plots de connexion de masse de la pastille dès la première série de tests de continuité de conduction.

La présente invention a tout d'abord pour objet un dispositif semi-conducteur qui comprend une pastille formant un circuit intégré, munie d'une multiplicité de plots de connexion sélective aux composants du circuit intégré, et une multiplicité de pattes de connexion extérieure reliées sélectivement auxdits plots de connexion de la pastille par une multiplicité de fils de connexion.

Selon l'invention, au moins une première desdites pattes de connexion extérieure, constituant une patte de connexion de masse, est reliée, par des fils de connexion, à au moins deux desdits plots de connexion de la pastille, constituant un premier et un second plots de masse dudit circuit intégré. Lesdits premier et second plots de masse de la pastille sont respectivement reliés à des première et seconde lignes de masse du circuit intégré. Lesdites première et seconde lignes de masse sont respectivement reliées à des troisième et quatrième plots de connexion de la pastille au travers de diodes de protection. Lesdits troisième et quatrième plots de connexion sont respectivement reliés à des deuxième et troisième pattes de connexion par des fils de connexion.

Selon l'invention, les liaisons d'une part entre ladite patte de connexion de masse et ladite seconde patte de connexion, au travers dudit premier fil de connexion de masse, ledit premier plot de connexion de masse, de ladite première ligne de connexion de masse, de la diode de protection, du troisième plot de connexion et du troisième fil de connexion et d'autre part entre ladite patte de connexion de masse et ladite troisième patte de connexion, au travers dudit second fil de connexion de masse, ledit second plot de connexion de masse, de ladite seconde ligne de connexion de masse, de la seconde diode de protection, du quatrième plot de connexion et du quatrième fil de connexion sont choisies de manière à présenter des caractéristiques géométriques et électriques égales ou voisines.

La présente invention a également pour objet un procédé pour tester le dispositif semi-conducteur précité.

Ce procédé consiste, selon l'invention, à brancher ladite patte de connexion de masse et lesdites pattes de connexion reliées auxdits troisième et quatrième plots de connexion de la pastille, aux bornes de deux sources de courant, à mesurer les tensions aux bornes de ces branchements, à calculer la différence entre ces tensions mesurées, et à comparer cette différence à une valeur de référence pour délivrer un signal de qualité des liaisons ou connexions de ladite patte de connexion de masse.

Le procédé selon l'invention peut en outre avantageusement consister à effectuer les mesures de tension précitées de façon séquentielle.

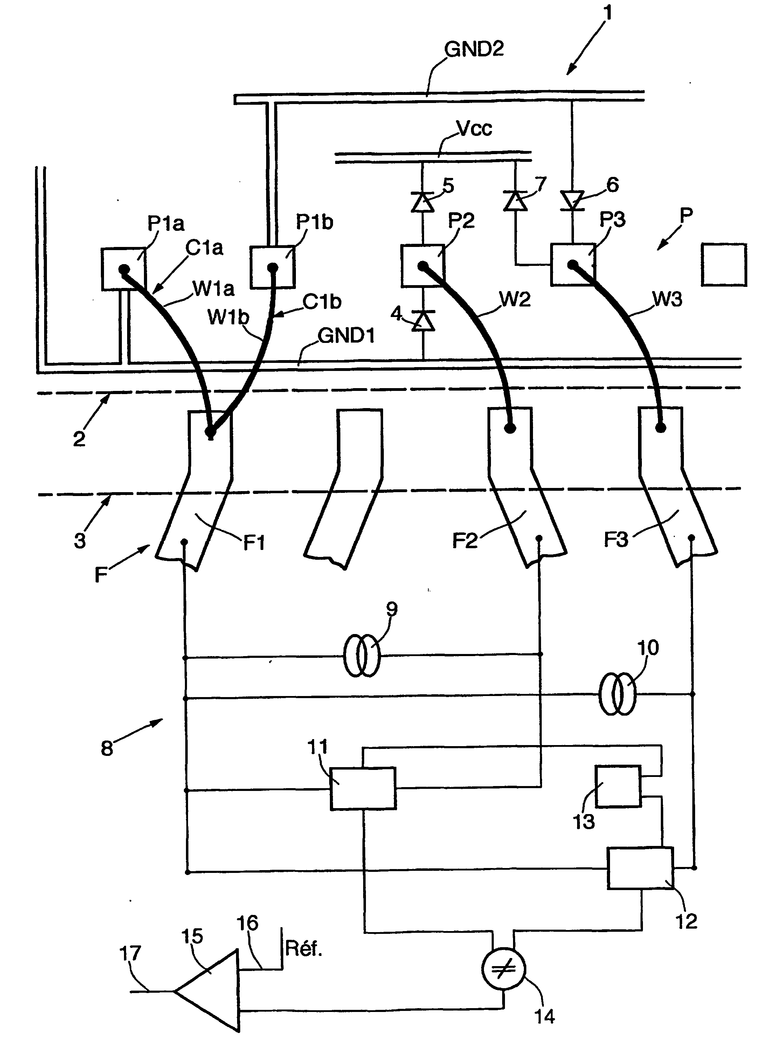

La présente invention sera mieux comprise à l'étude d'un dispositif semi-conducteur et d'un procédé pour tester sa fabrication, décrits à titre d'exemples non limitatifs et illustrés par la figure unique du dessin annexé qui montre, schématiquement une portion d'un dispositif semi-conducteur dans une représentation à plat et, schématiquement, un appareillage de tests de ce dispositif.

Le dispositif semi-conducteur représenté sur la figure unique, repéré d'une manière générale par la référence 1, comprend une pastille 2, formant un circuit intégré, qui présente, sur le bord périphérique de l'une de ses faces, une multiplicité de plots P de connexion sélective aux composants internes de ce circuit intégré, et qui comprend une multiplicité de pattes F de connexion extérieure reliées sélectivement aux plots de connexion P grâce à une multiplicité de fils métalliques W de connexion dont les extrémités sont sélectivement soudées sur les plots de connexion P de la pastille 2 et sur les pattes de connexion F.

Cet ensemble est noyé ou encapsulé dans une résine pour constituer un boîtier de circuit intégré 3 à la périphérie duquel dépassent les extrémités des pattes de connexion F en vue de la connexion de la pastille 2 à d'autres circuits notamment sur une plaque de circuits imprimés.

Dans l'exemple représenté, une patte F1 de connexion de masse du dispositif semi-conducteur 1 est reliée à un plot P1a de connexion de masse de la pastille 2 par l'intermédiaire d'un fil métallique de connexion W1a et est également reliée à un plot P1b de connexion de masse de la pastille 2 par l'intermédiaire d'un fil métallique de connexion W1b.

Le plot P1a est relié à une première ligne de masse GND1 du circuit intégré dans la pastille 2.

Le plot P1b est relié à une seconde ligne de masse GND2 du circuit intégré dans la pastille 2.

Dans un exemple, la première ligne de masse GND1 et la seconde ligne de masse GND2 sont destinées à constituer la masse de deux parties fonctionnellement distinctes intégrées dans la pastille 2. En particulier, la seconde ligne de masse GND2 est plutôt destinée à une partie non polluée du circuit intégré dans la pastille 2.

Des pattes de connexion F2 et F3, autres que des pattes de connexion de masse, sont respectivement reliées à des plots de connexion P2 et P3 de la pastille 2 par l'intermédiaire de fils métalliques de connexion W2 et W3.

Le plot de connexion P2 est au moins relié d'une part à la ligne de masse GND1 et d'autre part à une ligne d'alimentation Vcc par l'intermédiaire de diodes de protection 4 et 5.

Le plot de connexion P3 est au moins relié d'une part à la ligne de masse GND2 et d'autre part à la ligne d'alimentation Vcc par l'intermédiaire de diodes de protection 6 et 7.

Ainsi, les composants intégrés dans la pastille 2 sont protégés contre les décharges électrostatiques (ESD).

Cependant, les plots de connexion P2 et P3 ne sont pas directement reliés par le circuit intégré dans la pastille 2.

La structure du dispositif semi-conducteur 1 qui vient d'être décrite est non seulement constituée de manière à réaliser des connexions extérieures des différents composants intégrés dans la pastille 2 et les protéger, mais également constituée de manière à pouvoir en particulier tester la qualité des connexions réalisées par les fils de connexion de masse W1a et W1b par des tests de continuité de conduction, avant la réalisation de tests de fonctionnement des circuits intégrés dans la pastille 2.

Pour celà, on voit qu'on a représenté sur la figure un appareillage de tests repéré d'une manière générale par la référence 8, destiné à tester les connexions de masse de la pastille 2 reliées à la patte unique F1.

Cet appareillage 8 comprend un premier générateur de courant 9 dont les bornes sont respectivement reliées aux pattes de connexion F1 et F2 de la pastille 2 et un second générateur de courant 10 dont les bornes sont respectivement reliées aux pattes de connexion F1 et F3 de la pastille 2.

L'appareillage 8 comprend en outre un détecteur 11 de la tension entre les pattes de connexion F1 et F2 et un détecteur 12 de la tension entre les pattes de connexion F1 et F3, ces détecteurs 11 et 12 étant soumis à un séquenceur 13 et étant aptes à mémoriser la tension mesurée sur ordre de ce séquenceur.

L'appareillage 8 comprend également un soustracteur 14 apte à calculer la différence entre les valeurs des tensions mémorisées dans les détecteurs 11 et 12 et un comparateur 15 apte à comparer cette différence à une valeur de référence 16 qui lui est fournie, pour délivrer à sa sortie 17 un signal de validation ou de rejet en fonction de la valeur de la différence fournie par le soustracteur 14 par rapport au signal de référence 16.

Il résulte de ce qui précède que la chaîne de conduction C1a, constituée par la patte de connexion F1, le fil de connexion W1a, le plot de connexion P1a, la ligne de masse GND1, la diode de protection 4, le plot de connexion P2, le fil de connexion W2 et la patte de connexion F2, est reliée au générateur de courant 9 et au détecteur de tension 11.

En parallèle, la chaîne de conduction C1b, constituée par la patte de connexion F1, le fil de connexion W1b, le plot de connexion P1b la ligne de masse GND2, la diode de protection 6, le plot de connexion P3, le fil de connexion W3 et la patte de connexion F3 est reliée au générateur de courant 10 et au détecteur de tension 12.

L'appareillage 8, connecté comme décrit ci-dessus aux pattes de connexion de la pastille 2, peut fonctionner de la manière suivante.

On suppose tout d'abord que des tests classiques de présence des diodes de protection 4 et 6 dans le circuit intégré dans la pastille 2 ont été préalablement effectués et sont positifs.

En général, le test de la diode 4 consiste à relier les pattes de connexion F1 et F2 à une source de courant faible, par exemple de l'ordre de 1 à 10 mA, et à mesurer la tension entre ces pattes. Si cette tension est supérieure à une valeur déterminée, en général de l'ordre de 0,5Và 1V, la diode 4 est présente dans le circuit intégré.

Le test de la diode 6 peut être effectuer de la même manière en utilisant cette fois les pattes F1 et F3.

Pour que les tests classiques ci-dessus soient positifs, il suffit que l'un des fils de connexion de masse W1a et W1b soit présent. En effet, si la connexion entre la patte de connexion F1 et uniquement l'un des plots de connexion P1a et P1b, par le fil de connexion de masse correspondant, est absente, la tension désirée entre la patte de connexion F1 et les pattes de connexion F2 et F3 apparaît quand même du fait qu'un passage de courant s'établit entre les plots de connexion P1a et P1b au travers du substrat d'intégration dans la pastille 2.

Pour effectuer le test à l'aide de l'appareillage 8, les générateurs de courant 9 et 10 délivrent de préférence des courants de valeurs nettement plus élévées que celle du courant ayant servi à effectuer les tests de présence des diodes de protection 4 et 6. Par exemple, les générateurs 9 et 10 délivrent des courants de l'ordre de 20 à 40 mA.

Grâce au séquenceur 13, on active le générateur de courant 9 et le détecteur de tension 11, on mémorise dans ce dernier la valeur de la tension entre les pattes de connexion F1 et F2 et on les désactive. Après quoi, on active le générateur de courant 10 et le détecteur de tension 12, on mémorise dans ce dernier la valeur de la tension entre les pattes de connexion F1 et F3 et on les désactive.

Le soustracteur 14 calcule la différence entre lesdites valeurs de tension mesurées et délivre cette différence au comparateur 15.

Dans la mesure où ladite chaîne de conduction C1a est correctement fabriquée et dans la mesure où la chaîne de conduction C1b est également correctement fabriquée, le soustracteur 14 fournit au comparateur 15 un signal inférieur au signal de référence 16 prédéterminé, ce dernier étant par exemple de l'ordre de 0,2 à 0,4 V. Ce comparateur 15 délivre alors, à la sortie 17, un signal de validation du dispositif semi- conducteur 1 testé.

Si l'un des fils de connexion de masse W1a et W1b est coupé ou en court-circuit avec un autre fil de connexion ou bien que si les soudures de leurs extrémités sur respectivement la patte de connexion F1 et les plots de connexion P1a et P1b sont de mauvaise qualité ou inexistantes ou bien si les lignes de masse GND1 ou GND2 sont rompues, la différence délivrée par le soustracteur 14 sera largement supérieure à la valeur de référence prédéterminée 16. Le comparateur 15 délivre alors, à sa sortie 17, un signal de rejet du dispositif demi-conducteur 1 testé.

Comme il a été indiqué précédemment, en cas de défaillance de la liaison entre la patte F1 et le plot P1a par le fil de connexion W1a ou d'une rupture de la ligne de masse GND1, respectivement en cas de défaillance de la liaison entre la patte F1 et le plot P1b par le fil de connexion W1b ou d'une rupture de la ligne de masse GND2, un passage de courant peut s'établir, au cours des tests précités, entre les pattes de connexion F2 et F3, respectivement entre les pattes F1 et F2, du fait que le substrat d'intégration de la pastille 2 présente une certaine résistivité, de telle sorte qu'un passage de courant parallèle peut être détecté par l'appareillage de mesure 8.

Il convient naturellement que le choix de la valeur de référence prédéterminée 16 utilisée par le comparateur 15 tienne compte de ce courant parallèle et soit suffisamment haute pour que la différence des tensions qui en résulte, mesurées par les détecteurs 11 et 12, soit en dessous dudit seuil de référence 16. Les effets dudit passage de courant parallèle est cependant atténué dans le cas de dispositifs semi-conducteurs dans lesquels les composants intégrés dans la pastille 2 et reliés à la ligne de masse GND2 sont dans un caisson isolé intégré dans la pastille 2.

Par ailleurs, pour que la fixation de la valeur de référence 16 précitée et l'exécution du test précité soient plus aisées, il est souhaitable que les liaisons intégrées dans la pastille 2, d'une part entre les plots de connexion P1a et P2 par l'intermédiaire de la ligne de masse GND1 et de la diode de protection 4 et d'autre part entre les plots de connexion P1b et P3 par l'intermédiaire de la ligne de masse GND2 et de la diode de protection 6, présentent des caractéristiques géométriques et électriques égales ou très voisines afin que les chaînes de conduction C1a et C1b soient électriquement identiques ou très voisines. Ainsi, les générateurs de courant 9 et 10 peuvent avantageusement délivrer des courants identiques ou très voisins. Dans un exemple, dans la mesure où les chaines de conduction C1a et C1B sont correctes, les tensions mesurées par les détecteurs de tension 11 et 12 peuvent être de l'ordre de 0,5V à 1V.

## Revendications

1. Dispositif semi-conducteur comprenant une pastille formant un circuit intégré, munie d'une multiplicité de plots de connexion sélective aux composants du circuit intégré, et une multiplicité de pattes de connexion extérieure reliées sélectivement auxdits plots de connexion de la pastille par une multiplicité de fils de connexion,
au moins une première (F1) desdites pattes de connexion extérieure, constituant une patte de connexion de masse, étant reliée, par des fils de connexion (W1a, W1b), à au moins deux (P1a, P1b) desdits plots de connexion de la pastille (2), constituant un premier et un second plots de masse dudit circuit intégré,
lesdits premier et second plots de masse (P1a, P1b) dudit circuit intégré étant respectivement reliés à des première et seconde lignes de masse (GND1, GND2) du circuit intégré,
**caractérisé par le fait que** lesdites première et seconde lignes de masse (GND1, GND2) sont respectivement reliées à des troisième et quatrième plots de connexion (P2, P3) de la pastille au travers de diodes de protection (4, 6),
et que lesdits troisième et quatrième plots de connexion (P2, P3) sont respectivement reliés à des deuxième et troisième pattes de connexion (F2, F3) par des troisième et quatrième fils de connexion (W2, W3).

2. Dispositif semi-conducteur selon la revendication 1, **caractérisé par le fait que** les liaisons (C1a, C1b) d'une part entre ladite patte de connexion de masse (F1) et ladite seconde patte de connexion (F2), au travers dudit premier fil de connexion de masse (W1a), ledit premier plot de connexion de masse (P1a), de ladite première ligne de connexion de masse (GNDI), de la diode de protection (4), du troisième plot de connexion (P2) et du troisième fil de connexion (W2) et d'autre part entre ladite patte de connexion de masse (F1) et ladite troisième patte de connexion (F3), au travers dudit second fil de connexion de masse (W1b), ledit second plot de connexion de masse (P1b), de ladite seconde ligne de connexion de masse (GND2), de la seconde diode de protection (6), du quatrième plot de connexion (P3) et du quatrième fil de connexion (W3) sont choisies de manière à présenter des caractéristiques géométriques et électriques égales ou voisines.

3. Procédé pour tester le dispositif selon l'une quelconque des revendications précédentes, **caractérisé par le fait qu'**il consiste :
- à brancher ladite patte de connexion de masse (F1) et lesdites seconde et troisième pattes de connexion (F2, F3) reliées auxdits troisième et quatrième plots de connexion (P2, P3) de la pastille (2), aux bornes de deux sources de courant (9, 10),
- à mesurer les tensions (11, 12) aux bornes de ces branchements,
- à calculer (14) la différence entre ces tensions mesurées,
- et à comparer (15) cette différence à une valeur de référence (16) pour délivrer un signal de qualité (17) des liaisons ou connexion de masse de ladite patte de connexion de masse.

4. Procédé selon la revendication 3, **caractérisé par le fait qu'**il consiste à effectuer les mesures de tension précitées de façon séquentielle.

## Patentansprüche

1. Halbleiteranordnung mit einem eine integrierte Schaltung bildenden Chip, der mit mehreren Anschlußpunkten zum selektiven Anschließen von Komponenten der integrierten Schaltung und mit mehreren Anschlußflecken zum externen Anschließen (externe Anschlußflecken), die über mehrere Anschlußdrähte selektiv mit den Anschlußpunkten des Chip verbunden sind, versehen ist,
wobei mindestens ein erster (F1) der externen Anschlußflecken, der einen Erdungsanschlußfleck bildet, über Anschlußdrähte (W1a,W1b) mit mindestens zwei (P1a,P1b) der Anschlußpunkte des Chip (2) verbunden ist, die einen ersten und zweiten Erdungspunkt der integrierten Schaltung bilden,
wobei der erste und zweite Erdungspunkt (P1a, P1b) der integrierten Schaltung jeweils mit einer ersten und zweiten Erdungsleitung (GND1,GND2) der integrierten Schaltung verbunden sind,
**dadurch gekennzeichnet, daß** die erste und zweite Erdungsleitung (GND1,GND2) jeweils über Schutzdioden (4,6) mit einem dritten und vierten Anschlußpunkt (P2,P3) des Chip verbunden sind,
und dadurch, daß der dritte und vierte Anschlußpunkt (P2,P3) jeweils über einen dritten und vierten Anschlußdraht (W2,W3) mit einem zweiten und dritten Anschlußfleck (F2,F3) verbunden sind.

2. Halbleiteranordnung gemäß Anspruch 1, **dadurch gekennzeichnet, daß** die Verbindungen (C1a,C1b) einerseits zwischen dem Erdungsanschlußfleck (F1) und dem zweiten Anschlußfleck (F2) über den ersten Erdungsanschlußdraht (W1a), den ersten Erdungsanschlußpunkt (P1a), die erste Erdungsanschlußleitung (GND1), die Schutzdiode (4), den dritten Anschlußpunkt (P2) und den dritten Anschlußdraht (W2) und andererseits zwischen dem Erdungsanschlußfleck (F1) und dem dritten Anschlußfleck (F3) über den zweiten Erdungsanschlußdraht (W1b), den zweiten Erdungsanschlußpunkt (P1b), die zweite Erdungsanschlußleitung (GND2), die zweite Schutzdiode (6), den vierten Anschlußpunkt (P3) und den vierten Anschlußdraht (W3) so gewählt sind, um gleiche oder ähnliche geometrische und elektrische Eigenschaften aufzuweisen.

3. Verfahren zum Testen der Anordnung nach einem der vorstehenden Ansprüche, **dadurch gekennzeichnet, daß** es die folgenden Schritte aufweist:
Verbinden des Erdungsanschlußflecks (F1) und des zweiten und dritten Anschlußflecks (F2,F3), die mit dem dritten und vierten Anschlußpunkt (P2,P3) des Chip (2) verbunden sind, mit den Klemmen von zwei Stromquellen (9,10),
Messen der Spannungen (11,12) an den Klemmen dieser Zweige,
Berechnen (14) der Differenz zwischen diesen gemessenen Spannungen, und
Vergleichen (15) dieser Differenz mit einem Referenzwert (16), um ein Qualitätssignal (17) für die Qualität der Verbindungen oder des Erdungsanschlusses des Erdungsanschlußflecks auszugeben.

4. Verfahren nach Anspruch 3, **dadurch gekennzeichnet, daß** es das sequentielle Durchführen der obigen Spannungsmessungen aufweist.

## Claims

1. Semiconductor device comprising a chip forming an integrated circuit, which chip is provided with a multiplicity of pads for selective connection to the components of the integrated circuit, and comprising a multiplicity of external connection leads selectively connected to the said connection pads on the chip by a multiplicity of connection wires,
at least a first (F1) of the said external connection leads, constituting an earth connection lead, being connected, by connection wires (W1a, W1b), to at least two (P1a, P1b) of the said connection pads on the chip (2), constituting a first and a second earth pad of the said integrated circuit,
the said first and second earth pads (P1a, P1b) of the said integrated circuit being respectively connected to the first and second earth lines (GND1, GND2) of the integrated circuit,
**characterized in that** the said first and second earth lines (GND1, GND2) are respectively connected to third and fourth connection pads (P2, P3) on the chip via protective diodes (4, 6),
and **in that** the said third and fourth connection pads (P2, P3) are respectively connected to second and third connection leads (F2, F3) by third and fourth connection wires (W2, W3).

2. Semiconductor device according to Claim 1, **characterized in that** the connections (C1a, C1b) between, on the one hand, the said earth connection lead (F1) and the said second connection lead (F2), via the said first earth connection wire (W1a), the said first earth connection pad (P1a), the said first earth connection line (GDN1), the protective diode (4), the third connection pad (P2) and the third connection wire (W2) and between, on the other hand, the said earth connection lead (F1) and the said third connection lead (F3), via the said second earth connection wire (W1b), the said second earth connection pad (P1b), the said second earth connection line (GND2), the second protective diode (6), the fourth connection pad (P3) and the fourth connection wire (W3) are chosen so as to have the same or similar geometrical and electrical characteristics.

3. Method for testing the device according to either of the preceding claims, **characterized in that** it consists:
- in connecting up the said earth connection lead (F1) and the said second and third connection leads (F2, F3) connected to the said third and fourth connection pads (P2, P3) on the chip (2) to the terminals of two current sources (9, 10),
- in measuring the voltages (11, 12) across the terminals of these connection points,
- in calculating (14) the difference between these measured voltages, and
- in comparing (15) this difference with a reference value (16) in order to deliver a signal (17) relating to the quality of the earth connections of the said earth connection lead.

4. Method according to Claim 3, **characterized in that** it consists in carrying out the aforementioned voltage measurements in a sequential fashion.
